# EUROPEAN PATENT SPECIFICATION

(11) **EP 0 644 649 B1**
(45) Date of publication and mention of the grant of the patent: **01.12.2004**
(21) Application number: 94114813.2
(22) Date of filing: 20.09.1994
(51) Int. Cl.: H03F 3/217

(54) **A pulse width modulation amplifier**
Pulsbreitenmodulationsverstärker
Amplificateur à modulation de largeur d'impulsion

(30) Priority: 21.09.1993 JP 23452193
(43) Date of publication of application: 22.03.1995
(73) Proprietor: MATSUSHITA ELECTRIC INDUSTRIAL CO., LTD., Kadoma-shi, Osaka 571-8501 (JP)
(72) Inventor: Konno, Fumiyasu, Hirakata-shi, Osaka 572 (JP)
(74) Representative: Grünecker, Kinkeldey, Stockmair & Schwanhäusser Anwaltssozietät

(56) References cited:
- EP-A- 0 184 280
- DE-A- 3 925 159
- ELEKTRONIK, vol. 37, no. 23, 11 September 1988 MUNCHEN DE, pages 112-116, XP 000096719 H. SAX 'SCHALTEN STATT HEIZEN'
- NN: "Linear Databook 1", 1988, NATIONAL SEMICONDUCTOR CORPORATION,

## Description

The present invention relates to a pulse width modulation amplifier used for amplifying the output power of acoustic reproduction apparatuses and provides means for reducing the output offset voltage and output noise.

The conversion efficiency of pulse width modulation amplifiers is higher than that of typical class A, AB, and B amplifiers. For example, even the conversion factor of class B amplifiers which is generally spoken as having good conversion factor, is around 70 %, while, that of pulse width modulation amplifier can be 85 - 90 %. Accordingly, pulse width modulation amplifiers are widely used as low frequency amplifiers of acoustic apparatuses for vehicle use or as low frequency amplifiers for public address.

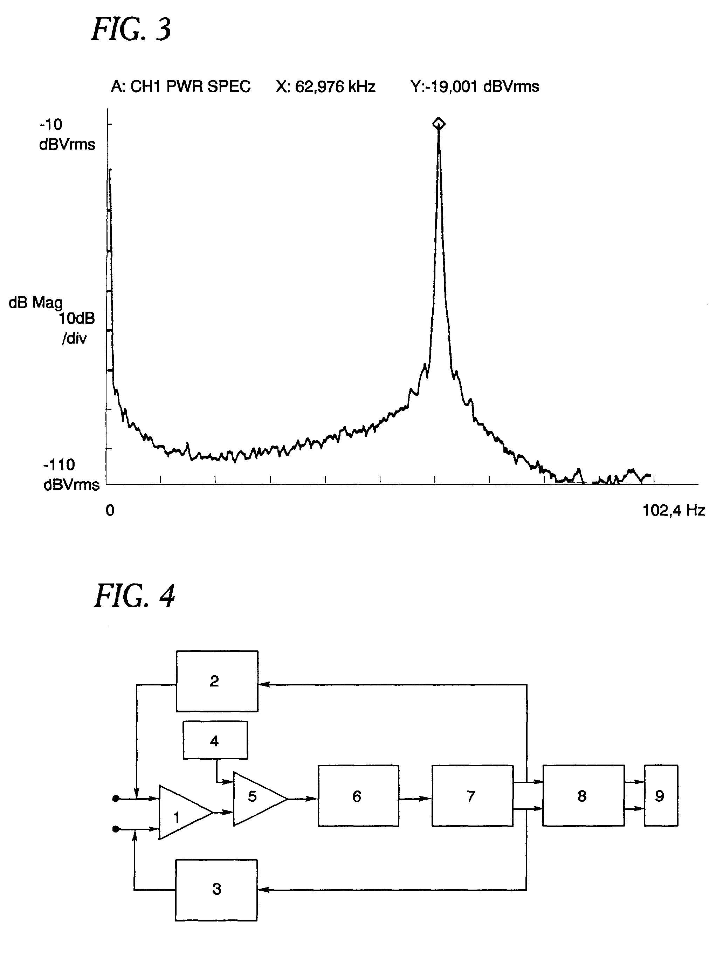

Hereinafter, a conventional example of pulse width modulation amplifier will be illustrated referring to drawings. Fig. 4 is a block diagram showing whole constitution of a conventional pulse width modulation amplifier. Pulse width modulation signal is generated through comparing, by using a comparator 5, the input signal amplified by an operational amplifier 1 and the triangular wave generated by a triangular oscillator 4. This pulse width modulation signal is amplified by a output stage driving circuit 6 to drive a final output stage 7. The output of the final output stage 7 is demodulated removing the carrier and higher harmonic by low pass filters 8 and the low frequency output power is supplied to a load 9.
In pulse width modulation amplifiers, FETs having low ON resistance and low driving current compared with transistors are widely employed as an amplifying device used in the output stage driving circuit 6 and the final output stage 7. H bridge connection constitution formed by connecting FETs in a H bridge like is generally employed in the final output stage 7.
Moreover, negative feedback is applied from the final output stage to the operational amplifier for improving the distortion factor, noise, etc., as an audio circuit. In these pulse width modulation amplifiers, the carrier of the same frequency ( hereinafter carrier) as the oscillation frequency of the triangular wave oscillator 4 must be eliminated before the negative feedback, thus low-pass filters are included in the feedback circuits 2 and 3.

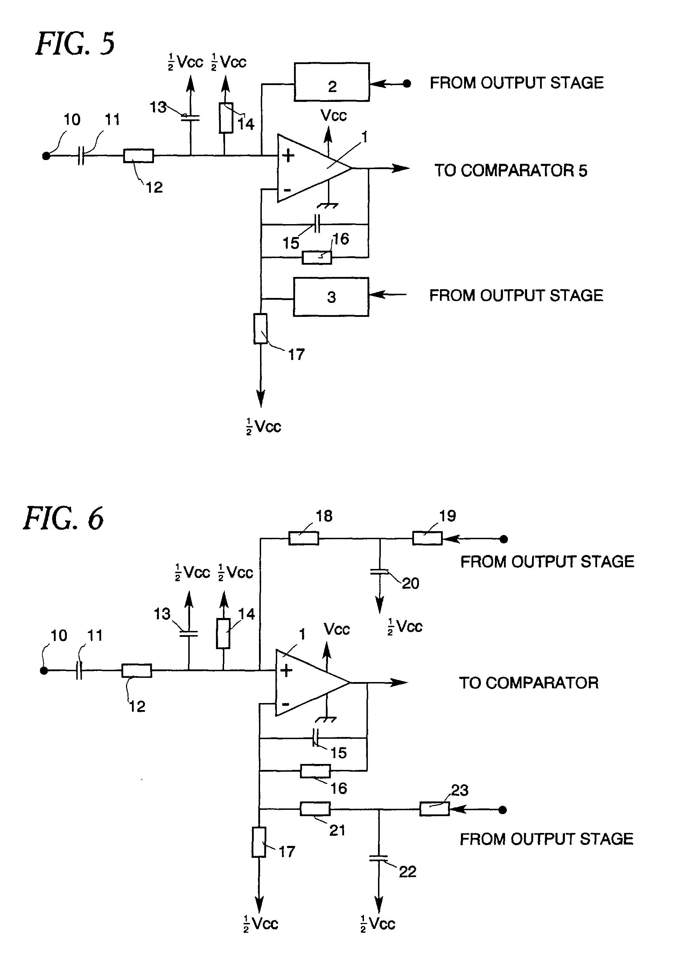

Fig. 5 is a circuit diagram showing around an operational amplifier 1 in said conventional pulse width modulation amplifier. A differential amplifier comprises an operational amplifier 1, capacitors 13, 15, resisters 12, 14, 16, and 17. Signal is input to an input terminal 10, passed through a capacitor 11, a resister 12, then applied to (+) terminal of the operational amplifier 1. Also, the output stage is connected to (+) and (-) terminals of the operational amplifier 1 through feedback circuits 2 and 3. Said capacitors 13 and 15 are the capacitors for limiting high frequency so that high frequency is not applied to the operational amplifier from the feedback circuits. According to the time constant when each of the capacities is C and each of the internal resistance of the feedback circuits 2 and 3 is R (not shown), a frequency$\text{fc = 1/2 π CR}$ (fc is generally around 20 kHz) becomes a cut-off frequency, that is, the frequency higher than this is not negatively feedbacked.

Fig. 6 shows around the operational amplifier 1 and the negative feedback circuits 2 and 3 of a conventional pulse width modulation amplifier. In the same manner as in Fig. 5, a differential amplifier comprises an operational amplifier 1, capacitors 13, 15 resistors 12, 14 16 and 17. The carrier and higher harmonic in the signal negative-feedbacked from the output stage is removed by a low-pass filter formed of a resister 19 and capacitor 20 and a low pass filter formed of a resistor 23 and capacitor 22, and then the signal is negative-feedbacked to (+) and (-) terminals of the operational amplifier through the resistors 18, 21 respectively. In this time, ground points of the capacitors for removing carrier and the ground points of the resistors 14, 17 of the input stage differential amplifier are the common and its voltage potential is :$\text{½ Vcc}$

However, in each of conventional examples mentioned above, the amplification degree of the operational amplifier 1 have to be increased in order to increase the amount of the negative feedback for improving the characteristics. But since the operational amplifier 1 is a direct current amplifier, increasing of the amplification degree may generate an offset voltage which is a deviation of the center voltage of the alternating signal to be amplified from the center voltage of the power source. In case of direct current amplification, direct current coupling is used for connection with the next amplification stage, thus the offset voltage is transmitted to the next amplification stage and there appears a unnegligiblly high offset voltage. Generation of this offset voltage may harm in getting big output by utilizing power source effectively.
Also, as the filters in the negative feedback circuits 2 and 3 are low pass filters, they are direct-current-coupled to the operational amplifier 1, the offset voltage of the amplification stage after the comparator 5 is also applied to the operational amplifier and this results in difficulty of enough correction of the offset voltage by only the operational amplifier 1.
Also, when the grounds of the low pass filters of the negative feedback circuits 2 and 3 and the ground of the operational amplifier 1 of the input step are common and the negative feedback circuits are direct-current-coupled to the operational amplifier 1, noise may increase since the carrier of the output step leakages to the operational amplifier 1.
Also, the frequency of the carrier of the conventional pulse width modulation amplifier shown in said Fig. 6 is higher than audible range (for example 63 kHz), and moreover, the signal negative feedbacked from the output stage includes switching noise remained in the output of FET circuit 7 of the final output stage, these make worse noise characteristics of whole circuit.

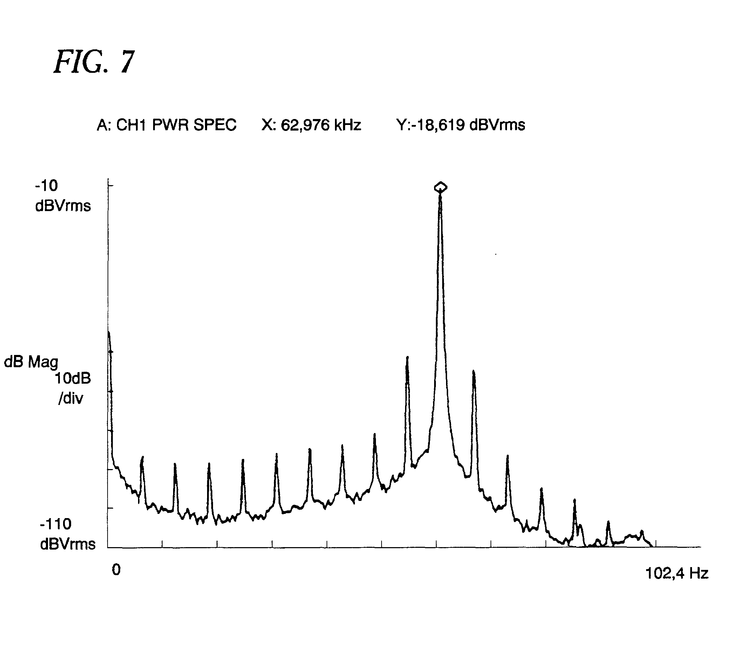

Fig. 7 is a frequency analysis of the voltage at the final output stage (both sides of the load 9 in Fig. 4) of the pulse width modulation amplifier shown in Fig. 4 including the operational amplifier 1 and negative feedback circuits shown in Fig. 6. Input voltage in this time is 0, only the residual noise of the amplifier is analyzed. It is seen that there are higher harmonics component and fractional harmonics component of the carrier and their complex, mixed, or modulated components besides the basic oscillation frequency 63 kHz, and audible range is also affected. The reason why these noise components are not eliminated by the low pass filters in Fig. 6 may be the capacitors of the low pass filters are grounded to the point of$\text{½ Vcc}$ due to the direct current coupling of the negative feedback circuits. That is, essentially speaking this point must be a perfect ground point, but it is considered that the impedance of the capacitor of the power source filter, for example, is not actually infinitesimal small, accordingly the noise component generated at the final output stage appears to the operational amplifier through the impedance of the power source and amplified then output.

EP-A-184 280 describes frequency-stabilized two-state modulation systems. One embodiment of such a system inputs an internal synchronizing signal. Another embodiment comprises a symmetric H-bridge output stage having two output terminals. In this embodiment, variable hysteresis is used to stabilize the switching frequency.

"Schalten statt heizen" by H. Sax (ELEKTRONIK, vol. 37, no. 23, September 11, 1988, Munich, Germany, pp. 112-116) describes a classical pulse width modulation amplifier. It amplifies an audio signal for a loudspeaker. The amplifier itself comprises a triangular wave oscillator. Furthermore, this document describes a pulse width modulation amplifier comprising an H-bridge output stage having four FETs. This amplifier comprises a comparator which has a hysteresis. The amplifier itself produces the modulation frequency. A further embodiment of this document discloses a circuit in which the amplitude of the audio input signal modifies the hysteresis of the comparator in order to stabilize the modulation frequency of the self-swinging pulse width modulation amplifier.

DE-A-3 925 159 discloses a further pulse width modulation amplifier circuit. One embodiment discloses a symmetric differential amplifier which comprises a triangular wave generator, a differential input circuit, two comparators, two driving circuits, two output stages and feedback resistors.

"Linear Databook 1" by National Semiconductor Corporation (1988 Edition, pp. 2-329 to 2-341) discloses several standard circuits for operational amplifiers. One of those circuits is an AC coupled non-inverting amplifier.

It is the object of the present invention to provide a pulse width modulation amplifier having excellent characteristics such as a small offset voltage of the final output stage and low output noise.

This object is achieved by a pulse width modulation amplifier according to claim 1. Preferred embodiments are the subject matters of the dependent claims. In the following, preferred embodiments of this invention are described referring to the accompanying drawings.
Fig. 1 is a circuit diagram showing constitution of the input portion of a pulse width modulation amplifier of the first embodiment of the present invention.
Fig. 2 is a circuit diagram showing constitution of the input portion and the negative feedback circuits of a pulse width modulation amplifier of the second embodiment of the present invention.
Fig. 3 is a output characteristics at no input signal of a pulse width modulation amplifier of the second embodiment of the present invention.
Fig. 4 is a block diagram showing whole constitution of a conventional pulse width modulation amplifier.
Fig. 5 is a circuit diagram showing constitution of input portion of a conventional pulse width modulation amplifier.
Fig. 6 is a circuit diagram showing constitution of the input portion and the negative feedback circuits of a conventional pulse width modulation amplifier.
Fig. 7 is a output characteristics at no input signal of a conventional pulse width modulation amplifier.

Hereafter, a pulse width modulation amplifier of the present invention will be illustrated referring to drawings. In the following illustration, parts having the same function as in the conventional pulse width modulation amplifier shown in Fig. 4, 5, and 6, are attached the same numbers and their illustration will be omitted.

### Embodiment 1

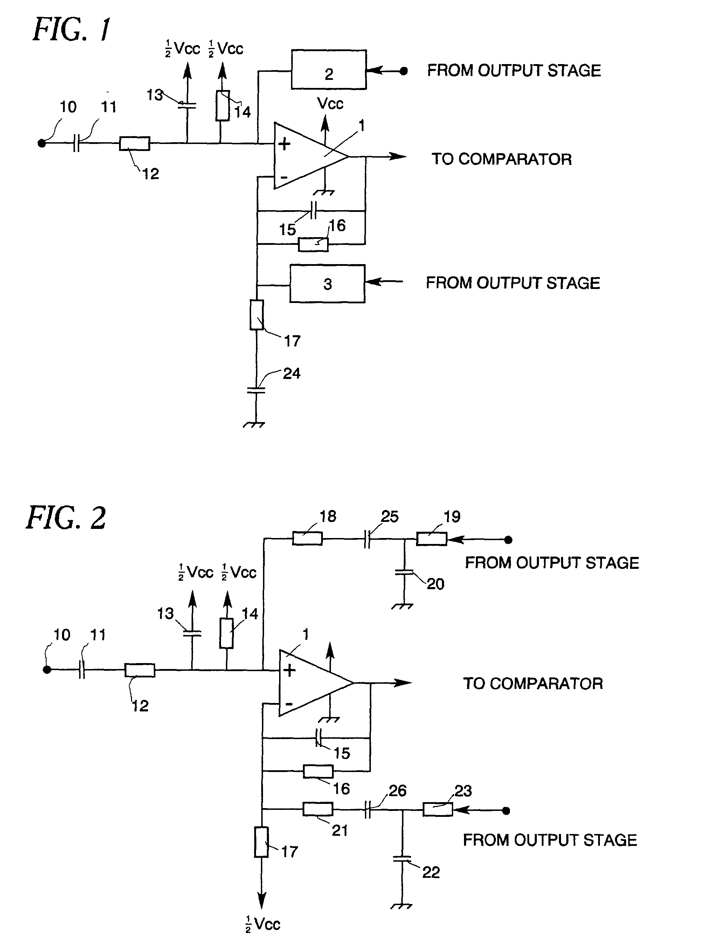

A pulse width modulation amplifier of a first embodiment of the present invention will be illustrated referring to Figures. Fig. 1 is a circuit diagram showing constitution of the input portion of a pulse width modulation amplifier of the first embodiment of the present invention. The different point from the conventional constitution shown in Fig. 5 is that resistor 17 connected to the (-) input terminal of the operational amplifier 1 is not connected to the center voltage$\text{(½)Vcc}$ but to the ground through capacitor 24. By this circuit constitution, the operational amplifier 1 becomes an alternating current amplifier, and when frequency is low, the capacitor 24 is C, and resistor 17 is R,$\text{Fc = 1/2 π CR [Hz]}$

This is a high pass filter having a cut off frequency of Fc. Since the operational amplifier 1 has become an alternating current amplifier, as the frequency characteristic decreases below Fc, the amplifying degree decreases and the gain becomes 1 at direct current.
Accordingly, the offset voltage is decreased independently to the gain of the operational amplifier until the inherent offset voltage of the operational amplifier itself. Since the operational amplifier has no direct current coupling with the next amplification stage, it does not give any influence to the offset voltage of the next amplification stage, resulting in reducing of the offset voltage of the final output stage.

### Embodiment 2

A pulse width modulation amplifier of a second embodiment of the present invention will be illustrated referring to drawings.
Fig. 2 is a circuit diagram showing constitution of the input portion and the negative feedback circuits of a pulse width modulation amplifier of the second embodiment of the present invention. The different point from the conventional constitution shown in Fig. 6 is that capacitors 20, 22 of low-pass filters constituting a negative feedback circuit are directly connected to the ground and feedback signals are feedbacked to the operational amplifier 1 after the direct current in feedback signal is cut by coupling capacitors 25. 26. In this circuit constitution, the coupling for negative feedback between the primary stage operational amplifier 1 and the negative feedback circuit from the final stage is not a direct current coupling but an alternating current coupling.
Fig. 3 shown the result of frequency analysis of the output voltage at no input signal in this circuit constitution. It is obvious that it has excellent characteristics of little leakage of higher harmonics component and noise component except the fundamental frequency of the carrier. This is considered that due to the change of negative feedback circuit from direct current coupling to alternating current coupling, capacitors 20. 22 can be directly grounded, so the influence of residual power source impedance is avoided, so the noise generated in the final output stage could not be transmitted through power source impedance to the operational amplifier so as to be amplified.

As mentioned above, by making the primary stage operational amplifier to an alternating current amplifier, the coupling with the next amplification stage becomes an alternating coupling resulting in reducing of the offset voltage of the final stage. Further, by an alternating coupling between the negative feedback circuits and the operational amplifier, the direct current component can be cut and eliminates influence of power source impedance so that the output noise can be decreased.

## Claims

1. A pulse width modulation amplifier comprising:
an operational amplifier (1) having an input signal applied to one of its input terminals;
a comparator (5) for comparing the output of said operational amplifier (1) and the output of a triangular wave oscillator (4);
an output stage driving circuit (6) connected to the output of said comparator (5);
a final output stage (7) connected to the output of said output stage driving circuit (6);
a filter (8) for demodulation connected to the output of said final output stage (7);
a load (9) connected to said filter for demodulation;
negative feedback circuits (2,3) for performing negative-feedback from the two output terminals of said final output stage (7) to the two input terminals of said operational amplifier, wherein each of said negative feedback circuits (2,3) includes a low-pass filter (19,20,22,23),
**characterised in that**
one end of each capacitor (20,22) of the resistor-capacitor serial circuits constituting said low-pass filters (19,20,22,23) is grounded, and negative feedback is applied from each connecting point between the capacitor and the resistor to the input terminals of said operational amplifier (1) through a coupling capacitor (25,26), so that each said negative feedback circuit and said operational amplifier are coupled by an alternating current coupling.

2. The pulse width modulation amplifier according to claim 1, **characterised in that** FETs are used in the output stage driving circuit (6) and the final output stage (7) as amplification devices.

3. The pulse width modulation amplifier according to claims 1 or 2, **characterised in that** H-bridge connection of FETs is used in the final output stage.

## Patentansprüche

1. Pulsbreitenmodulationsverstärker, der umfasst:
einen Operationsverstärker (1) mit einem Eingangssignal, das auf eine seiner Eingangsstellen angelegt wird;
einen Vergleicher (5) zum Vergleich der Ausgabe des Operationsverstärkers (1) und der Ausgabe eines Sägezahnoszillators (4);
eine Ausgangsstufen-Treiberschaltung (6), verbunden mit dem Ausgang des Vergleichers (5);
eine End-Ausgangsstufe (7), verbunden mit dem Ausgang der Ausgangsstufen-Treiberschaltung (6);
ein Filter (8) zur Demodulierung, verbunden mit dem Ausgang der End-Ausgangsstufe (7);
eine Last (9), verbunden mit dem Filter zur Demodulierung;
negative Rückkopplungsschaltungen (2, 3) zur Ausführung von negativer Rückkopplung von den beiden Ausgabestellen der End-Ausgangstufe (7) zu den beiden Eingabestellen des Operationsverstärkers, wobei jede der negativen Rückkopplungsschaltungen (2, 3) einen Tiefpassfilter (19, 20, 22, 23) einschließt,
**dadurch gekennzeichnet, dass**
ein Ende von jedem Kondensator (20, 22) der Widerstand-Kondensator-Seriellschaltungen, welche die Tiefpassfilter (19, 20, 22, 23) bilden geerdet ist und negative Rückkopplung von jedem Verbindungspunkt zwischen dem Kondensator und dem Widerstand zu den Eingabestellen des Operationsverstärkers (1) über einen Koppelkondensator (25, 26) angewandt wird, so dass jede negative Rückkopplungsschaltung und der Operationsverstärker durch eine Wechselstromkopplung gekoppelt sind.

2. Pulsbreitenmodulationsverstärker nach Anspruch 1, **dadurch gekennzeichnet, dass** FET's in der Ausgangsstufen-Treiberschaltung (6) und der End-Ausgangsstufe (7) als Verstärkungsvorrichtungen verwendet werden.

3. Pulsbreitenmodulationsverstärker nach Anspruch 1 oder 2, **dadurch gekennzeichnet, dass** eine H-Brücken- Verbindung von FET's bei der End-Ausgangsstufe verwendet wird.

## Revendications

1. Amplificateur à modulation de largeur d'impulsion comprenant :
un amplificateur opérationnel (1) qui a un signal d'entrée appliqué à l'une de ses bornes d'entrée ;
un comparateur (5) pour comparer la sortie dudit amplificateur opérationnel (1) et la sortie d'un oscillateur d'onde triangulaire (4) ;
un circuit d'entraînement d'étage de sortie (6) raccordé à la sortie dudit comparateur (5) ;
un étage de sortie final (7) raccordé à la sortie dudit circuit d'entraînement d'étage de sortie (6) ;
un filtre (8) de démodulation raccordé à la sortie dudit étage de sortie final (7) ;
une charge (9) raccordée au dit filtre de démodulation ;
des circuits de réaction négative (2, 3) pour exécuter une réaction négative depuis les deux bornes de sortie dudit étage de sortie final (7) jusqu'aux deux bornes d'entrée dudit amplificateur opérationnel, dans lequel chacun desdits circuits de réaction négative (2, 3) inclut un filtre passe-bas (19, 20, 22, 23),
**caractérisé en ce que**
une extrémité de chaque condensateur (20, 22) desdits circuits en série de résistances - de condensateurs constituant lesdits filtres passe-bas (19, 20, 22, 23) est mise à la terre et la réaction négative est appliquée à partir de chaque point de connexion entre le condensateur et la résistance aux bornes d'entrée dudit amplificateur opérationnel (1) à travers un condensateur de couplage (25, 26) de telle sorte que chaque dit circuit de réaction négative et chaque dit amplificateur opérationnel sont couplés par un couplage de courant alternatif.

2. Amplificateur à modulation de largeur d'impulsion selon la revendication 1, **caractérisé en ce que** des TEC's (Transistor à Effet de Champ) sont utilisés dans le circuit d'entraînement d'étage de sortie (6) et dans l'étage de sortie final (7) en tant que dispositifs d'amplification.

3. Amplificateur à modulation de largeur d'impulsion selon les revendications 1 ou 2, **caractérisé en ce que** le montage en pont H des TEC's est utilisé dans l'étage de sortie final.
